# EUROPÄISCHE PATENTANMELDUNG

(11) **EP 2 045 358 A2**
(43) Veröffentlichungstag der Anmeldung: **08.04.2009**
(21) Anmeldenummer: 08015374.5
(22) Anmeldetag: 03.09.2008
(51) Int. Cl.: C23C 16/44, C23C 16/455

(54) **Verringerung des Verbrauchs von Prozessgasen bei der chemischen Gasphasenabscheidung von siliziumhaltigen Schichten bei der als Reaktionsprodukt neben der abzuscheidenden Schicht Wasserstoff entsteht**

(30) Priorität: 11.09.2007 DE 102007043156
(71) Anmelder: Näbauer, Anton, 80805 München (DE)
(72) Erfinder: Näbauer, Anton, 80805 München (DE)

(57) **Zusammenfassung**

Verringerung des Verbrauchs von Prozessgasen bei der chemischen Gasphasenabscheidung von siliziumhaltigen Schichten bei der als Reaktionsprodukt neben der abzuscheidenden Schicht Wasserstoff entsteht

Die Erfindung betrifft ein Verfahren zur Verringerung des Gasverbrauchs von Prozessgasen bei der chemischen Gasphasenabscheidung von siliziumhaltigen Schichten bei der als Reaktionsprodukt neben der abzuscheidenden Schicht hauptsächlich Wasserstoff entsteht
wobei
ein wesentlicher Teil des Gasgemisches vom Gasauslass (28) der Prozesskammer zum Gaseinlass (27) der Prozesskammer rezirkuliert wird,

## Beschreibung

Die Erfindung betrifft ein Verfahren zur Verringerung des Verbrauchs von Prozessgasen bei der chemischen Abscheidung von siliziumhaltigen Schichten aus der Gasphase (CVD = chemical vapor deposition) bei der als Reaktionsprodukt Wasserstoff entsteht.
Siliziumschichten werden insbesondere in der Mikroelektronik-Halbleiterfertigung in großem Umfang benötigt. Hierbei spielt in erster Linie die Schichtqualität die dominierende Rolle, wodurch der Kostenaspekt des Gasverbrauchs in den Hintergrund tritt.
In verstärktem Maße werden Siliziumschichten aber für Solarzellen benötigt, wobei die Kosten der Rohmaterialien eine bedeutende Rolle spielen und an die Schichtqualität sonst nicht so hohe Anforderungen wie in der Mikroelektronik gestellt werden.

Das Verfahren eignet sich bei der Gasphasenabscheidung von Siliziumschichten oder siliziumhaltigen Schichten (z. B. dotierte Siliziumschichten) sofern als Reaktionsprodukt neben der abzuscheidenden Schicht hauptsächlich Wasserstoff als Abfallprodukt entsteht.
Die Besonderheit von Wasserstoff liegt darin, dass Wasserstoff relativ leicht, zum Beispiel mit Hilfe von wasserstoffselektiven Membranen, selektiv aus einem Gasgemisch entfernt werden kann.

Das Verfahren wird am Beispiel der Gasphasenabscheidung von Silizium (amorph, mikrokristallin, polykristallin, einkristallin) unter Verwendung von Silan als Prozessgas (Reaktant) dargestellt. Grundsätzlich eignet sich das Verfahren nicht nur für die Herstellung von Siliziumschichten aus Silan, sondern für viele andere Abscheidungen mit vergleichbaren chemischen Reaktionen. Einige davon werden später noch aufgeführt.
Die Gasphasenabscheidung kann grundsätzlich durch ein geeignetes und übliches Verfahren (Plasma (PECVD), Wärme, Laser, Hot wire, ...) unterstützt werden.

Bei der Abscheidung von Silizium läuft die wesentliche chemische Reaktion in der Prozesskammer nach folgender Gleichung ab.

SiH₄ → Si + 2 H₂

Silizium scheidet sich als Schicht ab, während Wasserstoff als Abgas die Prozesskammer verlässt.
In einer Variation des Prozesses kann dem Reaktionsgas noch Wasserstoff zugemischt werden.

Für die Reaktionsgleichung gilt dann:

SiH₄ + n H₂ → Si + (2+n) H₂

Der Wasserstoff dient zum einen als Trägergas, zum anderen wird durch das Mischungsverhältnis Silan zu Wasserstoff das Reaktionsgleichgewicht beeinflusst, und somit auch die Schichteigenschaften und die Abscheiderate beeinflusst.

Bei einem typischen Abscheideprozess der nach der Reaktion SiH₄ → Si + 2 H₂ abläuft, wird nur ein relativ geringer Anteil (5 % ... 20 %) von Silan zu Silizium umgesetzt. Das ungenutzte Silan verlässt die Prozesskammer und wird in der Regel einer Abgasbehandlung unterzogen, wobei es beispielsweise zu SiO₂ weiter reagieren kann.

Der Erfindung liegt die Aufgabe zugrunde, den Verbrauch an Prozessgas zu reduzieren bei einer chemischen Gasphasenabscheidung bei der neben der abzuscheidenden Schicht als Reaktionsprodukt hauptsächlich Wasserstoff entsteht.

Dies wird erfindungsgemäß dadurch gelöst, dass das Abgas, in dem sich noch ein wesentlicher Anteil von unverbrauchten Reaktanten (im Beispiel Silan) befindet rezirkuliert (d. h. wieder der Prozesskammer zugeführt wird) wird, und / oder erst gar nicht aus der Prozesskammer entfernt wird. Der in Folge der Reaktion bei der chemischer Gasphasenabscheidung entstandene Wasserstoff wird hingegen selektiv entfernt.
Das selektive Entfernen des Wasserstoffs kann beispielsweise mit Hilfe einer für Wasserstoff permeablen Membran erfolgen. Diese Wasserstoff-permeable-Membran kann sich dabei in der Prozesskammer selbst, oder an einer anderen Stelle im Bereich des Abgasleitungssystems befinden. Eine weitere Möglichkeit den Wasserstoff selektiv teilweise zu entfernen ist, den Wasserstoff in Metallgitter einzubauen, wie es bei Metallhydridspeichern für Wasserstoff üblich ist.
Da ein solcher Metallhydridspeichen nur eine begrenzte Aufnahmenkapazität für Wasserstoff hat, ist dann noch ein System erforderlich, das sicher stellt, dass der Wasserstoff wieder aus dem Metallgitter herauskommt (und gegebenenfalls gereinigt und wieder verwendet wird).

Eine Weiterbildung des erfindungsgemäßen Verfahrens sieht vor, dass in einem Reaktor nacheinander verschiedene Schichten hergestellt werden. Insbesondere ist es bei der Herstellung von Solarzellen oder Photovoltaik Dünnschicht Solarmodulen interessant, dass nacheinander in unterschiedlicher Reihenfolge p-dotierte, n-dotierte und undotierte Halbleiterschichten (insbesondere Silizium und Siliziumverbindungen mit Kohlenstoff und Germanium) hergestellt werden. Hierbei werden nacheinander verschieden Gasmischungen in die Prozesskammer eingebracht und damit Schichten unterschiedlicher Zusammensetzung hergestellt. Bei den Abscheidungen, bei denen als Reaktionsprodukt hauptsächlich Wasserstoff entsteht, und bei denen nach dem beschriebenen Verfahren der Verbrauch an Prozessgasen reduziert werden kann, werden die Prozessgase jeweils individuell (nach Gaszusammensetzung) zwischengespeichert und rezirkuliert. Der Systemteil, der dies bewerkstelligt wird als Pump-/ Speichersystem bezeichnet.
Ein derartiges Pump-/ Speichersystem kann beispielsweise aus mehreren Sorptionspumpen oder durch ein System aus Pumpe und Druckspeicher aufgebaut werden.

Da bei den rezirkulierten Gasen in der Regel auch ein wesentlicher Anteil Wasserstoff dabei ist, kann es von Vorteil sein, in das Pump-/ Speichersystem auch einen eigenen Speicher für Wasserstoff z. B. einen Metallhydridspeicher einzubauen.

Die Erfindung betrifft ferner ein mit dem erfindungsgemäßen Verfahren hergestelltes Photovoltaikmodul.

Die Erfindung wird im Folgenden beispielhaft anhand der beiliegenden Figuren erläutert. Es stellen dar:
Fig. 1. Beispiel für den Aufbau eines CVD - Systems bei dem die Prozessgase rezirkuliert werden.
Fig. 2. Beispiel für den Aufbau eines CVD - Systems bei dem die Prozessgase rezirkuliert werden, mit zusätzlicher Pumpe die den Druck über der Wasserstoff-permeabler-Membran erhöht.
Fig. 3. Beispiel für den Aufbau eines CVD - Systems bei dem die Prozessgase zwischengespeichert und rezirkuliert werden.
Fig. 4. Beispiel für den Aufbau eines CVD - Systems bei dem die Prozessgase rezirkuliert werden, und mit dem nacheinander Schichten verschiedener Zusammensetzung abgeschieden werden können, wobei die Gasgemische individuell rezirkuliert und gespeichert werden können

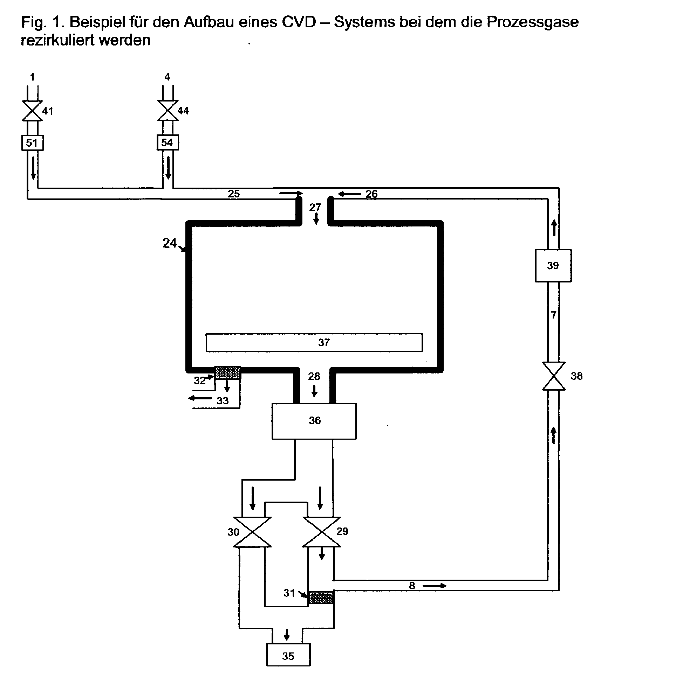

Legende für beide Fig. 1, Fig. 2, Fig. 3, Fig. 4 und Fig. 5
1. Einlass 1 für Prozessgas 1 (Reaktant oder Trägergas; im Beispiel: SiH₄)
2. Einlass 2 für Prozessgas 2 (Reaktant oder Trägergas; im Beispiel: B₂H₆)
3. Einlass 3 für Prozessgas 3 (Reaktant oder Trägergas; im Beispiel: PH₃)
4. Einlass 4 für Prozessgas 4 (Reaktant oder Trägergas; im Beispiel: H₂)
5. Einlass 5 für Purgegas
6. Einlass 6 für Reinigungsgas
8. Gasleitung zum Rezirkulieren der Prozessgase
9. Zuführung zum Pump-/ Speichersystem für Schichtzusammensetzung 1
10. Zuführung zum Pump-/ Speichersystem für Schichtzusammensetzung 2
11. Zuführung zum Pump-/ Speichersystem für Schichtzusammensetzung 3
12. Absperrventil am Eingang zum Pump-/ Speichersystem für Schichtzusammensetzung 1
13. Absperrventil am Eingang zum Pump-/ Speichersystem für Schichtzusammensetzung 2
14. Absperrventil am Eingang zum Pump-/ Speichersystem für Schichtzusammensetzung 3
15. Pump- / Speichersystem für die Gase für Schichtzusammensetzung 1 (im Beispiel sind das die Gase SiH₄, H₂ und B₂H₆ zur Herstellung von p-dotiertem Silizium)
16. Pump- / Speichersystem für die Gase für Schichtzusammensetzung 2 (im Beispiel sind das die Gase SiH₄ und H₂ zur Herstellung von undotiertem Silizium)
17. Pump- / Speichersystem für die Gase für Schichtzusammensetzung 3 (im Beispiel sind das die Gase SiH₄, H₂ und PH₃ zur Herstellung von n-dotiertem Silizium)
18. Absperrventil am Ausgang von Pump-/ Speichersystem für Schichtzusammensetzung 1
19. Absperrventil am Ausgang von Pump-/ Speichersystem für Schichtzusammensetzung 2
20. Absperrventil am Ausgang von Pump-/ Speichersystem für Schichtzusammensetzung 3
21. Mass-flow-controller für rezirkuliertes Gas für Schichtzusammensetzung 1
22. Mass-flow-controller für rezirkuliertes Gas für Schichtzusammensetzung 2
23. Mass-flow-controller für rezirkuliertes Gas für Schichtzusammensetzung 3
24. Prozesskammer
25. Gasleitung für Zufuhr von Prozessgasen von den Gasquellen zum Einlass der Prozesskammer
26. Gasleitung für rezirkulierte Gase zum Einlass der Prozesskammer
27. Gaseinlass zur Prozesskammer
28. Gasauslass aus der Prozesskammer
29. Absperrventil für Gasauslass über Wasserstoff-permeable-Membran
30. Absperrventil für allgemeinen Gasauslass
31. Wasserstoff-permeable-Membran im Bereich des Abgassystems
32. Wasserstoff-permeable-Membran im Bereich der Prozesskammer
33. Leitung zum Entfernen von Wasserstoff aus der Prozesskammer
34. Pumpe zur Druckerhöhung vor Wasserstoff-permeabler-Membran (optional)
35. Pumpe (nicht immer erforderlich) zum Abpumpen der Prozessgase bei CVD Verfahren die in der Prozesskammer mit Unterdruck arbeiten (insbesondere LPCVD und PECVD)
36. Pumpe (nicht immer erforderlich) zum Abpumpen der Prozessgase bei CVD Verfahren die in der Prozesskammer mit Unterdruck arbeiten (insbesondere LPCVD und PECVD). Diese Pumpe kann gegebenenfalls ersetzt oder kombiniert sein durch ein Druckregelungssystem zum Regeln des Kammerdrucks
37. Substrat auf das Schicht abgeschieden werden soll
38. Absperrventil in Rezirkulationsleitung
39. Pumpe in Rezirkulationsleitung
40. Überdruckventil und/oder Druckminderer (nicht immer erforderlich)
41. Absperrventil für Prozessgas 1
42. Absperrventil für Prozessgas 2
43. Absperrventil für Prozessgas 3
44. Absperrventil für Prozessgas 4
45. Absperrventil für Purge-Gas
46. Absperrventil für Reinigungsgas
48. Pump-/Speichersystem für Prozessgase
49. Absperrventil
50. Mass-flow controller
51. Mass-flow-controller für Prozessgas 1
52. Mass-flow-controller für Prozessgas 2
53. Mass-flow-controller für Prozessgas 3
54. Mass-flow-controller für Prozessgas 4
55. Mass-flow-controller für Purge-Gas
56. Mass-flow-controller für Reinigungsgas
57. Messgerät zur Analyse der Gaszusammensetzung

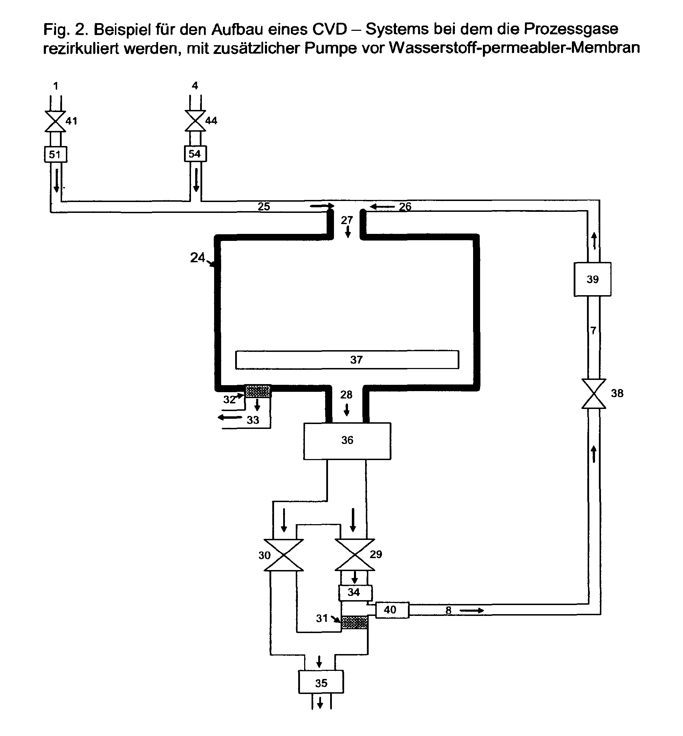

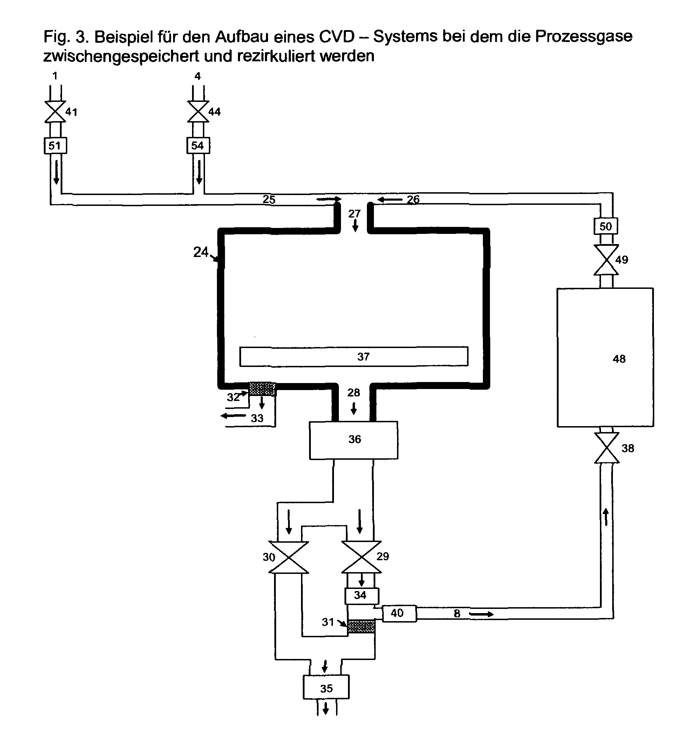

Anhand von Fig. 1 wird das Verfahren am Beispiel der Abscheidung einer Siliziumschicht aus Silan erklärt. Weiterbildungen davon sind in Fig. 2 und Fig. 3 veranschaulicht.

Die Prozessgase SiH₄ und H₂, die an den Eingängen 1 und 4 vorhanden sind, werden im richtigen Mischungsverhältnis über die geöffneten Ventile (41, 44) und die Mass-flow-controller (51, 54) sowie über die Leitungen 25 und 27 in die Prozesskammer eingebracht.
In der Prozesskammer liegen die für die Abscheidung geeigneten Bedingungen (Temperatur, Druck, Plasma, ...) vor. Auf dem Substrat (37) wird eine Schicht von undotiertem Silizium abgeschieden. Als weiteres Reaktionsprodukt entsteht Wasserstoff. In dem Maße, wie bei der Reaktion Wasserstoff entsteht, muss dieser auch wieder entfernt werden. Bei geschlossenem Ventil (30) und geöffnetem Ventil (29) kann dies beispielsweise entweder über eine Wasserstoff-permeable-Membran (32) in der Prozesskammer und der damit verbundenen Ableitung (33) erfolgen (wenn Membran (31) nicht vorhanden ist, ist sie durch eine undurchlässige Wand zu ersetzen) oder über das Ventil (29), die Wasserstoff-permeable-Membran (31) und die Pumpe (35). Daneben ist auch eine Kombination der beiden beschrieben Möglichkeiten der Wasserstoff-Ableitung denkbar. Weiterhin kann ein Fachmann noch eine Reihe weiterer Stellen im Abgassystem (zum Abgssystem gehören, sofern vorhanden, die Teile 28, 29, 30, 31, 34, 35, 36, 40) der CVD Anlage finden, an denen der Wasserstoff sinnvoll abgeleitet werden kann.
In einer Weiterbildung der Erfindung ist vor der Wasserstoff-permeablen-Membran eine zusätzliche Pumpe zur Erhöhung des Drucks auf die Membran vorgesehen (siehe Fig. 2). Damit wird - bei gleicher Membrangröße die Menge, des Wasserstoffs gesteigert, der über die Membran abgeführt wird. Diese ist insbesondere bei CVD-Systemen, die mit reduziertem Druck arbeiten (z. B. LPCVD = Low pressure CVD und PECVD = Plasma enhanced CVD) sinnvoll, da sonst wegen der geringen Drücke eine sehr großflächige Membran erforderlich wäre. Sofern vor der Membran ein ausreichend hoher Druck aufgebaut ist, können die Prozessgase über Überdruckventil bzw. Druckminderer (40), Leitung (8), das geöffnete Ventil (38) und die Systemteile (7, 39, 26, 27) in die Prozesskammer rezirkuliert werden.
Die Pumpe (39) (kann möglicherweise durch einen Mass-flow-controller ergänzt oder ersetzt werden) dient dabei dazu, den Gasfluss im Rezirkulationssystem besser einstellen zu können.

In einer Weiterbildung der Erfindung, die in Fig. 3 zu sehen ist, ist im Rezirkulationssystem zusätzlich ein Speichersystem (48) vorgesehen. Damit können die Prozessgase bevor sie wiederum in die Prozesskammer rezirkuliert werden zwischengespeichert werden. Mit Hilfe des Ventils (49) und des Mass-flowcontrollers (50) kann die Menge des rezirkulierten Prozessgases dann besser - insbesondere unabhängiger vom Angebot des Prozessgases im Abgasysytem - gesteuert werden.
Weiterhin kann es aufgrund der Druckverhältnisse sinnvoll sein, wenn das Speichersystem mit einer Pumpe kombiniert wird. Aus diesem Grund wird in dieser Beschreibung auch die umfassendere Bezeichnung Pump- / Speichersystem" bezeichnet. Ein "Pump- / Speichersystem" gemäß dieser Beschreibung beinhaltet daher mindestens entweder eine Pumpe oder ein Speichersystem. Es kann aber auch aus einer Kombination von Pumpen und Speichern sowie weiteren Systemteilen bestehen.
Erfindungsgemäße Möglichkeiten für den Aufbau eines Pump-/Speichersystems sind unter anderem:
- System unter Verwendung von mindestens zwei Gas-Einfang-Pumpen (insbesondere Sorptionspumpen), bei denen die Gase zunächst eingefangen werden, und später wieder kontrolliert abgegeben werden. Während die eine Sorptionspumpe das zu rezirkulierende Prozessgas aus dem Abgassystem aufnimmt, gibt die andere Pumpe das in einem früheren Zyklus gespeicherte Gas zur Rezirkulation wieder ab.
- System unter Verwendung mindestens einer Pumpe und mindestens einer Druckkammer. Hierbei wird das Prozessgas aus dem Abgassystem in einen Druckspeicher zwischengespeichert.

Vorteil der Rezirkulation ist auch, dass der Gasdurchfluss durch die Prozesskammer relativ hoch werden kann, und damit leichter eine gleichmäßige Verteilung der Prozessgase innerhalb der Prozesskammer erreicht werden kann.

Das Verfahren ist keineswegs genau an den in Fig. 1, 2, und 3 gezeigten Aufbau der Anlage für die chemische Gasphasenabscheidung (CVD-System) beschränkt. Ein Fachmann kann noch eine Vielzahl von Modifikationen des CVD-Systems angeben, mit denen das beschriebene Verfahren durchgeführt werden kann.

Das Verfahren ist keineswegs auf die Abscheidung von reinen Siliziumschichten begrenzt, sondern es eignet sich für eine Vielzahl von chemischen Abscheidungen aus der Gasphase. Im Folgenden sind beispielhaft einige der dafür geeigneten Reaktionen zusammengefasst.

| Beispiele für geeignete Reaktionen bei der chemischen Gasphasenabscheidung | | |
|---|---|---|
| SiH₄ | → | Si + 2H₂ |
| SiH₄ + n H₂ | → | Si + (2+n) H₂ |
| GeH₄ | → | Ge + 2 H₂ |
| GeH₄ + n H₂ | → | Ge + (2+n) H₂ |
| x SiH₄ + (1-x) CH₄ | → | SiₓC(₁₋ₓ) + 2 H₂ |
| x SiH₄ + (1-x) CH₄ + n H₂ | → | SiₓC(₁₋ₓ) + (2 + n) H₂ |
| x SiH₄ + (1-x) GeH₄ | → | SiₓGe(₁₋ₓ) + 2 H₂ |
| x SiH₄ + (1-x) GeH₄ + n H₂ | → | SiₓGe(₁₋ₓ) + (2 + n) H₂ |
| x B₂H₆ + (1-x) SiH₄ | → | Silizium mit Bor dotiert + Wasserstoff |
| x B₂H₆ + (1-x) SiH₄ + n H₂ | → | Silizium mit Bor dotiert + Wasserstoff |
| x PH₃ + (1-x) SiH₄ | → | Silizium mit Phosphor dotiert + Wasserstoff |
| x PH₃ + (1-x) SiH₄ + n H₂ | → | Silizium mit Phosphor dotiert + Wasserstoff |

Neben den reinen halbleitenden Schichten (Silizium und Germanium) kommen weiterhin in Frage: Halbleitende Mischschichten aus Silizium, Germanium und Kohlenstoff (SiₓC(₁₋ₓ) SiₓGe₍₁₋ₓ₎), die mit Hilfe von B₂H₆ oder PH₃ p- oder n- dotiert werden können.
Auch ist es möglich anstatt Monosilan auch andere Silizium-WasserstoffVerbindungen zu verwenden, wobei jedoch entsprechend folgendem Beispiel für Disilan, die Gleichungen modifiziert werden müssen.

### Si₂H₆ → 2 Si + 3 H₂

Vergleichbares gilt auch für die Germanium-Wasserstoffverbindungen und die Kohlen-Wasserstoffverbindungen.

Weiterhin können den Prozessgasen Gase zugemischt sein, die nicht an der chemischen Reaktion beteiligt sind wie zum Beispiel Edelgase (z. B. Helium, Argon, ...) die aber die Eigenschaften der abgeschieden Schicht beeinflussen können. Diese Beeinflussung kann beispielsweise auch über eine Sputterwirkung des Edelgases während der Abscheidung im Plasma sein.
Zu Beachten ist auch, dass die Reaktionen nicht immer ausschließlich nach den hier dargestellten Formeln ablaufen, sondern dass parallel noch andere Reaktionen ablaufen. Das entscheidende ist, dass am Ausgang der Prozesskammer noch Gase vorhanden sind, die einen Anteil von gasförmigen Siliziumverbindungen enthalten, aus denen bei einer Rezirkulation zurück in die Prozesskammer gegebenenfalls unter Zumischung von weiteren Gasen (insbesondere Verbindungen mit Silizium wie z. B. Silan) wieder siliziumhaltige Schichten hergestellt werden können.

Um die optimale Mischung der Prozessgase einstellen zu können, kann die Gaszusammensetzung in der Rückführung und / oder in der Prozesskammer und / oder in der Gaszuführung zur Prozesskammer beispielsweise durch einen Massenspektrometer online analysiert werden und können abhängig vom Analyseergebnis die Massflowcontroller für die Prozessgase (51, 52, 53, 54, 55, 56) individuell gesteuert werden. Die Steuerung der Gasflüsse kann noch verbessert werden, wenn noch zusätzliche Informationen über die Gaszusammensetzung in anderen Systemteilen (z. B. im Pump und Speichersystem) vorliegen.

Anhand eines Beispiels soll das Einsparpotential an Prozessgas veranschaulicht werden. Dieses Beispiel ist idealisiert durch die Annahme, dass Monosilan nur zu Silizium und Wasserstoff reagiert und keine weiteren Reaktionen parallel ablaufen. Das Beispiel wird anhand von Fig. 1 erläutert.

Am Gaseinlass der Prozesskammer (27) werden über einen bestimmten Zeitabschnitt 95 Mol Wasserstoff und 5 Mol Silan zugeführt.
Am Ausgang der Prozesskammer werden daraus nachdem ein Mol Silan zu 2 Mol Wasserstoff und 1 Mol Silizium (als Schicht abgeschieden) reagiert hat: 97 Mol Wasserstoff und 4 Mol Silizium. Durch die Wasserstoffmembran (31) (Membran 32 ist in diesem Beispiel nicht vorhanden) werden beispielsweise 4 Mol Wasserstoff aus dem System herausgeführt. Zurückgeführt zur Prozesskammer über die Gasleitung (26) werden dann 4 Mol Silan und 93 Mol Wasserstoff, denen dann über die Gasleitung (25) von den Gasquellen 1 Mol Silan und 2 Mol Wasserstoff zugeführt werden. Damit kommen am Gaseinlass der Prozesskammer wieder 5 Mol Silan und 95 Mol Wasserstoff an.

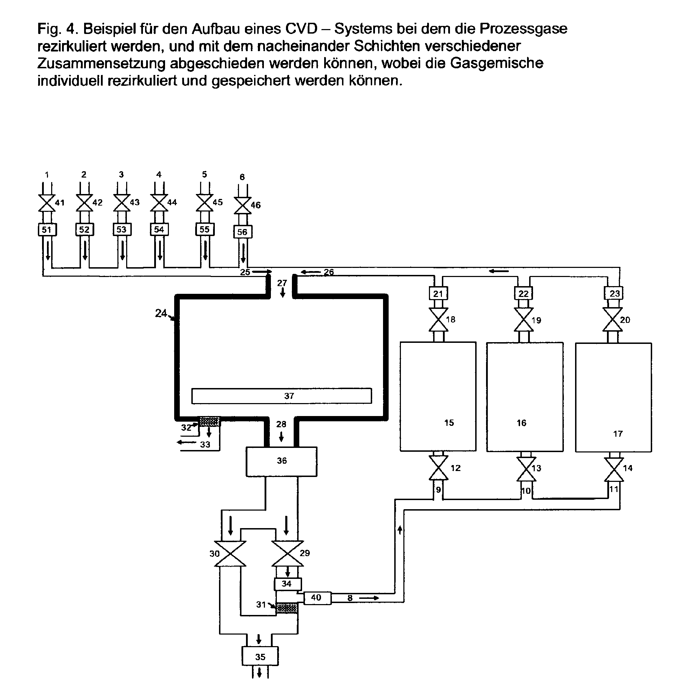

Im Folgenden wird anhand Fig. 4 eine Weiterbildung des Verfahrens erläutert, mit dem mehrere aufeinander folgende Schichten mit verschiedener Zusammensetzung mit geringem Gasverbrauch hergestellt werden können.
Beispielhaft werden wesentliche (teilweise sich wiederholende) Schritte der Herstellung der halbleitenden Silizium-Schichten einer Dünnschicht-Solarzelle mit der Schichtfolge pin (p-dotiertes, intrinsisches (reines), n-dotiertes Silizium) erläutert.

### 1. Teilschritt: Reinigung

Ventile (12, 13, 14, 18, 19, 20, 41, 42, 43, 44, 45) sind geschlossen. Über das geöffnete Ventil (46) und den Mass-flow.controller (56) wird das an (6) anliegende Reinigungsgas eingebracht und das System gereinigt. Ventile 29, 30 sind geöffnet.

### 2. Teilschritt: Purge

Das System wird mit einem Gas durchgespült (gepurged; z. B. mit Helium); hierbei sind die Ventile (12, 13, 14, 18, 19, 20, 41, 42, 43, 44, 46) geschlossen und Ventile 29 und 30 geöffnet. Über das ebenfalls geöffnete Ventil 45 und den Mass-flow controller (55) wird das "Purge-Gas" eingebracht.

### 3. Teilschritt: Herstellung der p-dotierten Siliziumschicht

Die an 1,2,und 4 anliegenden Prozessgase SiH₄, B₂H₆, und H₂ werden im richtigen Mischungsverhältnis über die geöffneten Ventile (41, 42, 44) und die Mass-flow-controller (51, 52, 54) in die Prozesskammer eingebracht.
In der Prozesskammer liegen die für die Abscheidung geeigneten Bedingungen (Temperatur, Druck, Plasma, ...) vor. Auf dem Substrat (37) wird eine Schicht von p-dotiertem Silizium abgeschieden. Als weiteres Reaktionsprodukt entsteht Wasserstoff, der bei geschlossenem Ventil (30) und geöffnetem Ventil (29) beispielsweise entweder über eine Wasserstoff-permeable-Membran (32) in der Prozesskammer und der damit verbundenen Ableitung (33) oder über das Ventil (29), die Wasserstoff-permeable-Membran (31) und die Pumpe (35) entfernt werden kann. Daneben ist auch eine Kombination der beiden beschrieben Möglichkeiten der Wasserstoff-Ableitung denkbar. Weitere Einzelheiten zur Ableitung des Wasserstoff, insbesondere die Funktion der gegebenenfalls vorhandenen Pumpe (34) und Überdruckventil / Druckminderer (40) wurden bereits früher erläutert und gelten hier sowie in Teilschritt 4 und Teilschritt 5 entsprechend.

In der Prozesskammer befindet sich ein Gasgemisch aus SiH₄, H₂, und B₂H₆, das nach teilweiser Entfernung des Wasserstoff bei geschossenen Ventilen (13, 14, 19, 20) über die Systemteile (34, 40, 8, 9) und Ventil 12 dem Pump-/ Speichersystem für die Gase für p-dotiertes Silizium zugeführt wird. Weitere Einzelheiten zum Pump-/Speichersystem sind in der Erläutung zu Fig. 3 zu finden.
Hier werden die Gase gegebenenfalls zwischengespeichert und über Ventil (18) und Mass-flow-controller (21) sowie Leitung (26) wieder der Prozesskammer zugeführt.

Zum Beenden der Abscheidung von p-Silizium wird durch Schließen der Ventile (12, 18, 41, 42, 44) die Rezirkulation der Prozessgase und die Zufuhr von SiH₄, H₂, und B₂H₆ über die Mass flow-controller (51, 52, 54) unterbunden.
Gegebenenfalls muss durch einen Purge-Schritt noch restliches Prozessgas aus Prozesskammer und Leitungen entfernt werden.

### 4. Teilschritt: Herstellung einer undotierten Siliziumschicht

Abscheidung erfolgt wie in Teilschritt 3 wobei nur die Prozessgase SiH₄ und H₂ verwendet werden und kein Dotiergas beigemischt ist.

Die an 1 und 4 anliegenden Prozessgase SiH₄ und H₂ werden im richtigen Mischungsverhältnis über die geöffneten Ventile (41, 44) und die Mass-flow-controller (51, 54) in die Prozesskammer eingebracht.
In der Prozesskammer liegen die für die Abscheidung geeigneten Bedingungen (Temperatur, Druck, Plasma, ...) vor. Auf dem Substrat (37) wird eine Schicht von undotiertem Silizium abgeschieden. Als weiteres Reaktionsprodukt entsteht Wasserstoff, der wie bei Teilschritt 3 beschrieben aus dem System entfernt werden kann.

In der Prozesskammer befindet sich ein Gasgemisch aus SiH₄, und H₂ das nach teilweiser Entfernung des Wasserstoff bei geschossenen Ventilen (12, 14, 18, 20) über die Systemteile (34, 40, 8, 10) und Ventil 13 dem Pump-/ Speichersystem für die Gase für un-dotiertes Silizium zugeführt wird.

Hier werden die Gase gegebenenfalls zwischengespeichert und über Ventil (19) und Mass-flow-controller (22) sowie Leitung (26) wieder der Prozesskammer zugeführt.

Zum Beenden der Abscheidung von undotiertem Silizium wird durch Schließen der Ventile (13, 19, 41, 44) die Rezirkulation der Prozessgase und die Zufuhr von SiH₄, und H₂ über die Mass-flow-controller (51, 54) unterbunden.
Gegebenenfalls muss durch einen Purge-Schritt noch restliches Prozessgas aus Prozesskammer und Leitungen entfernt werden.

### 5. Teilschritt: Herstellung der n-dotierten Siliziumschicht

Die an 1,3,und 4 anliegenden Prozessgase SiH₄, PH₃ und H₂ werden im richtigen Mischungsverhältnis über die geöffneten Ventile (41, 43, 44) und die Mass-flow-controller (51, 53, 54) in die Prozesskammer eingebracht.
In der Prozesskammer liegen die für die Abscheidung geeigneten Bedingungen (Temperatur, Druck, Plasma, ...) vor. Auf dem Substrat (37) wird eine Schicht von n-dotiertem Silizium abgeschieden. Als weiteres Reaktionsprodukt entsteht Wasserstoff, der wie bei Teilschritt 3 beschrieben aus dem System entfernt werden kann.

In der Prozesskammer befindet sich ein Gasgemisch aus SiH₄, H₂, und PH₃, das nach teilweiser Entfernung des Wasserstoff bei geschossenen Ventilen (12, 13, 18, 19) über die Systemteile (34, 40, 8, 11) und Ventil 14 dem Pump-/ Speichersystem für die Gase für n-dotiertes Silizium zugeführt wird.
Hier werden die Gase gegebenenfalls zwischengespeichert und über Ventil 20 und Mass-flow-controller (23) sowie Leitung (26) wieder der Prozesskammer zugeführt.

Zum Beenden der Abscheidung von n-Silizium wird durch Schließen der Ventile (14, 20, 41, 43, 44) die Rezirkulation der Prozessgase und die Zufuhr von SiH₄, H₂, und PH₃ über die Mass-flow-controller (51, 53, 54) unterbunden.
Gegebenenfalls muss durch einen Purge-Schritt noch restliches Prozessgas aus Prozesskammer und Leitungen entfernt werden.

Das Verfahren ist keineswegs genau an den in Fig. 4 gezeigten Aufbau der Anlage für die chemische Gasphasenabscheidung (CVD-System) beschränkt. Ein Fachmann kann noch eine Vielzahl von Modifikationen des CVD-Systems angeben, mit denen das beschriebene Verfahren durchgeführt werden kann.

### Abscheidesystem mit Rezirkualtion von Gasen ohne Wasserstoffpermeable Membran.

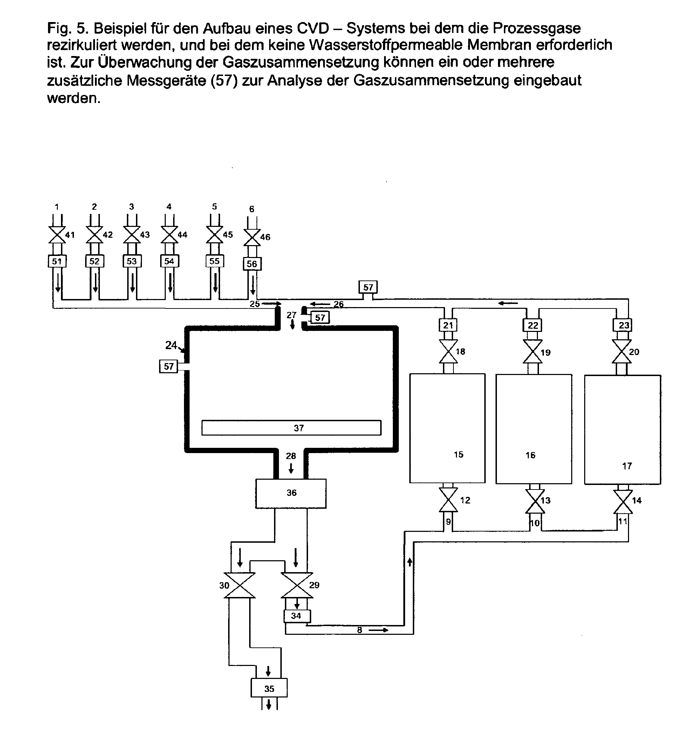

Fig 5 zeigt eine weitere Weiterbildung der Erfindung, bei der eine Wasserstoffpermeable Membran nicht mehr unbedingt notwendig ist.
Häufig soll das Prozessgas (das über 27 in die Prozesskammer geleitet wird) bei der Herstellung der Siliziumhaltigen Schichten (insbesondere bei mikrokristallinem oder nanokristallinem Silizium) größere Mengen Wasserstoff enthalten. Wenn in dem gesamten System keine Wasserstoff permeable Membran vorgesehen ist, enthält das Gas infolge der in der Prozesskammer stattfindenden Reaktion am Ausgang der Prozesskammer eine noch größere Menge Wasserstoff.
In diesem Fall kann ein wesentlicher Anteil (z. B. 75%) der Gase am Ausgang der Prozesskammer rezirkuliert werden, während der Rest der Gase das CVD System (über 35 in Fig 5) verlässt. Da der Silizium-Anteil (in Form von unterschiedlichen siliziumhaltigen Verbindungen) geringer ist als er beim Einlass in die Prozesskammer sein sollte, ist es nötig bei der Zuführung der Quellengasen über 25 den Anteil der Siliziumhaltigen Gase (z. B. Silan) entsprechend höher einzustellen.
Um die optimale Mischung der Prozessgase einstellen zu können, ist es ratsam die Gaszusammensetzung in der Rückführung und / oder in der Prozesskammer und / oder in der Gaszuführung zur Prozesskammer durch ein Messgerät (57) (beispielsweise durch einen Massenspektrometer) online zu analysieren und abhängig vom Analyseergebnis die Einlässe der Prozessgase (über 51 ... 56) zu steuern.
An einem Beispiel für die Abscheidung von mikrokristallinem oder amorphen Silizium mit einer stark Wasserstoffhaltigen Gasmischung soll die Wirksamkeit dieses Verfahrens stark vereinfacht dargestellt werden.
Durch den Einlass werden in die Prozesskammer werden 5% Silan und 95 % (% bezogen auf Volumen unter Standardbedingungen unter der Annahme von idealen Gasen) Wasserstoff eingebracht (insgesamt werden innerhalb einer bestimmten Zeit 100 Mol eingebracht; d. h. 5 Mol Silan und 95 Mol Wasserstoff).
Nach der Reaktion in der Prozesskammer sind aus diesen 100 Mol beispielsweise 101 Mol geworden: 4 Mol Silan und 97 Mol Wasserstoff. Darüber hinaus wurde Silizium abgeschieden (ein Mol (Mono-)Silan ergibt nach der Reaktion 2 Mol Wasserstoff und 1 Mol Silizium).
Man könnte jetzt vom Gas am Ausgang der Prozesskammer ca. 2 % abzweigen und dem Abgassystem zuführen, und die restlichen 98% rezirkulieren. Damit werden ca. 4 Mol Silan und ca. 95 Mol Wasserstoff rezirkuliert. Um das korrekte Mischungsverhältnis einzustellen wird vor einem Wiedereintritt in die Prozesskammer nur noch eine Zugabe von ca. 1 Mol Silan benötigt.

Da im Gas am Ausgang der Prozesskammer nicht nur Silan und Wasserstroff vorhanden sein werden, sondern auch eine Reihe von Zwischenprodukten präsent sein können empfiehlt es sich, die Zusammensetzung der Gasströme zu analysieren und dementsprechend das Mischungsverhältnis der zuzuführenden Gase einzustellen.

Grundsätzlich zeigt das Beispiel, dass insbesondere dann, wenn ein hoher Wasserstoffanteil in der Prozesskammer gewünscht wird (wie dies insbesondere bei der Herstellung von mikrokristallinem Silizium der Fall ist), durch ein Rezirkulieren der Gase auch ohne Wasserstoffpermeable Membran sehr attraktiv ist. Vergleichbare Betrachtungen können auch bezüglich der Herstellung dotierter Schichen unter Verwendung von Phosphin und Diboran angestellt werden.
Auch die Verwendung von C₃H₉O₃B (Trimethyboron) ist möglich, da über kurz oder lang auch Kohlenstoff und der Sauerstoff über das Abgassystem wieder aus dem CVD-System herausgebracht werden.
Vorteilhaft ist es auch wenn das Verhältnis, des Gases, das zurückgeführt wird, und das als Abgas das System verlässt dynamisch, in Abhängigkeit der jeweiligen Gaszusammensetzungen gesteuert wird.

## Patentansprüche

1. Verfahren zur Verringerung des Gasverbrauchs von Prozessgasen bei der chemischen Gasphasenabscheidung von siliziumhaltigen und / oder Germaniumhaltigen Schichten bei der als Reaktionsprodukt neben der abzuscheidenden Schicht hauptsächlich Wasserstoff entsteht
wobei
ein wesentlicher Teil des Gasgemisches vom Gasauslass der Prozesskammer zum Gaseinlass der Prozesskammer rezirkuliert wird,

2. Verfahren zur Verringerung des Gasverbrauchs von Prozessgasen bei der chemischen Gasphasenabscheidung von siliziumhaltigen und / oder Germaniumhaltigen Schichten bei der als Reaktionsprodukt neben der abzuscheidenden Schicht hauptsächlich Wasserstoff entsteht
wobei
Wasserstoff selektiv aus dem System zur chemischen Gasphasenabscheidung, entfernt wird
und
die Prozessgase (Reaktanten), aus denen noch siliziumhaltige Schichten hergestellt werden können im System verbleiben oder vom Gaseinlass zum Gasauslass rezirkuliert werden.

3. Verfahren nach einem der Ansprüche 2 **dadurch gekennzeichnet dass,** Wasserstoff mit Hilfe einer Wasserstoff-permeablen-Membran aus dem System entfernt wird.

4. Verfahren nach Ansprüche 3 **dadurch gekennzeichnet dass**, sich mindestens eine Wasserstoff-permeable-Membran in der Prozesskammer befindet.

5. Verfahren nach Ansprüche 3 oder 4 **dadurch gekennzeichnet dass,** sich mindestens eine Wasserstoff-permeable-Membran in Gasleitungssystem hinter dem Gasauslass der Prozesskammer befindet.

6. Verfahren nach einem der Ansprüche 1, 2, 3, 4 oder 5 **dadurch gekennzeichnet dass,**
es sich bei dem System zur chemischen Gasabscheidung um ein System handelt bei dem ein niedriger Druck in der Prozesskammer vorliegt (LPCVD: Low Pressure Chemical Vapor Deposition).

7. Verfahren nach einem der Ansprüche 1, 2, 3, 4, 5 oder 6 **dadurch gekennzeichnet dass,** es sich bei dem System zur chemischen Gasabscheidung um ein Plasma verstärktes Abscheidesystem handelt (PECVD: Plasma Enhanced Chemical Vapor Deposition).

8. Verfahren nach einem der Ansprüche 1, 2, 3, 4, 5, 6 oder 7 **dadurch gekennzeichnet dass,**
als Prozessgas unter anderem Silan (SiH₄) verwendet wird.

9. Verfahren nach einem der Ansprüche 1, 2, 3, 4, 5, 6,7 oder 8 **dadurch gekennzeichnet dass,**
im Prozessgas unter anderem Diboran (B₂H₆) und oder Phosphin (PH₃) enthalten ist.

10. Verfahren nach einem der Ansprüche 1, 2, 3, 4, 5, 6, 7, 8 oder 9 **dadurch gekennzeichnet dass,**
im Prozessgas unter anderem German (GeH₄) und oder Methan (CH₄) enthalten ist.

11. Verfahren nach einem der Ansprüche 1, 2, 3, 4, 5, 6, 7, 8, 9 oder 10 **dadurch gekennzeichnet dass,**
die Gase, die rezirkuliert werden in einem Pump- / Speichersystem zwischengespeichert werden, und nach Bedarf abgerufen werden können.

12. Verfahren nach Anspruch 11 **dadurch gekennzeichnet, dass** das Pump- / Speichersystem realisiert wird mit Hilfe eines Systems von Sorptionspumpen oder mit Hilfe eines Überdruckspeichers der von einer Pumpe befüllt wird.

13. Verfahren nach Anspruch 11 oder 12 **dadurch gekennzeichnet, dass** für die aufeinander folgende Abscheidung mehrere Schichten mit unterschiedlicher Zusammensetzung mehrere Pump- / Speichersystem vorgesehen sind, über die unterschiedliche Gasmischungen individuell zwischen gespeichert und rezirkuliert werden können.

14. Verfahren nach einem der Ansprüche 1, 2, 3, 4, 5, 6, 7, 8, 9, 10, 11, 12 oder 13 **dadurch gekennzeichnet dass** ein oder mehrere online Messgeräte zur Analyse der Gaszusammensetzung an verschieden Stellen des Systems verwendet werden um die Zufuhr der einzelnen Prozessgase zu steuern.

15. Dünnschicht Solarmodul, das unter Verwendung einer der in Anspruch 1 ... 14 beschriebenen Techniken hergestellt wird.
